# EUROPEAN PATENT SPECIFICATION

(11) **EP 0 432 414 B1**
(45) Date of publication and mention of the grant of the patent: **24.05.1995**
(21) Application number: 90119962.0
(22) Date of filing: 18.10.1990
(51) Int. Cl.: H03B 11/00, H03B 17/00

(54) **Millimeter radiation source**
Millimeter-Strahlungsquelle
Source de rayonnement millimétrique

(30) Priority: 15.12.1989 US 451339
(43) Date of publication of application: 19.06.1991
(73) Proprietor: International Business Machines Corporation, Armonk, N.Y. 10504 (US)
(72) Inventor: May, Paul G., Croton-on-Hudson, N.Y. 10520 (US)
(74) Representative: Schäfer, Wolfgang, Dipl.-Ing.

(56) References cited:
- US-A- 4 127 784
- PHYSICAL REVIEW LETTERS vol. 59, no. 15, October 12, 1987, NEW YORK US pages1663 - 1666; D. GRISCHOWSKY ET AL.: 'ELECTROMAGNETIC SHOCK WAVES FROMTRANSMISSION LINES '
- IBM TECHNICAL DISCLOSURE BULLETIN vol. 31, no. 12, May 12, 1989, NEW YORK USpages 392 - 393; 'RESONANT PHOTOCONDUCTIVE CAVITY '
- APPLIED PHYSICS LETTERS vol. 48, no. 12, March 24, 1986, NEW YORK US pages 751- 753; M. B. KETCHEN ET AL.: 'GENERATION OF SUBPICOSECOND ELECTRICAL PULSES ONCOPLANAR TRANSMISSION LINES '
- IEEE TRANSACTIONS ON MICROWAVE THEORY vol. 37, no. 1, January 1989, NEW YORK USpages 43 - 50; HRAYR A. SAYADIAN: 'GENERATION OF HIGH-POWER BROAD-BANDMICROWAVE PULSES BY PICOSECOND OPTOELECTRONIC TECHNIQUE '
- IEEE JOURNAL OF QUANTRUM ELECTRONICS vol. QE-22, no. 1, January 1986, NEW YORKUS pages 108 - 111; P. PAULUS ET AL.: 'GENERATION OF MICROWAVE PULSES BYOPTOELECTRONICALLY SWITCHED RESONATORS '

## Description

This invention relates to generation of millimeter radiation. In particular the invention pertains to an integrated millimeter radiation source and waveguide.

Many uses of microwave radiation, such as collision-avoidance radars, have large volume markets that require low cost components. One approach to satisfy these requirements is based on integrated circuit antennas. These antennas radiate primarily into the substrate and a problem often encountered is loss of energy to surface waves, resulting in a loss of antenna efficiency.

This invention involves a unique geometry of the substrate such that as much as of the energy as possible is coupled to surface waves - i.e the energy is waveguided and then emitted at an aperture. This approach is particularly appropriate for a distributed antenna based on transmission lines (e.g. coplanar transmission lines).

Reference is made to Infrared and Millimeter waves, vol. 10 chap. 1, "Integrated - Circuit Antennas", Rutledge et al., Academic Press, 1983. This reference describes various configurations used for making integrated circuit antenna. It also discusses some of the limitations to antenna efficiency, including energy lost as surface waves.

From Grischkowsky et al, "Electromagnetic Shock Waves for Transmission Lines", Phys. Rev. Lett. 59, 1663 (1987) a system for generating millimeter waves radiation having the features of the first part of claim 1 is known. The article describes a particular coplanar transmission configuration where pulses on Aluminum lines deposited on a Silicon Sapphire (SOS) substrate radiate into the substrate at an efficiency dependent on the characteristic frequency.

Reference is made to M.B. Ketchen, et al, "Generation of Picosecond Electrical Pulses on Coplanar Transmission Lines", Appl. Phy. Lett. 48 (12), 24 March 1986, pp.751-753. This publication describes techniques to generate ultrashort electrical pulses by photoconductively shorting charged transmission lines across narrow gaps.

The generation of fast electrical pulses utilizing photoconductive resonant cavities has also been proposed in the literature. Reference is made to IBM Technical Disclosure Bulletin Volume 31, No. 12 pp.392-393, May 1989. This publication discloses the use of a photoconductive resonant cavity in which the cavity length is matched to the repetition rate of the excitation optical source, such as a semiconductor diode. The resonant cavity is defined by having impedance discontinuities in the transmission line and is selected so that the round trip time of an electrical pulse is equal to the period of laser oscillations or a multiple thereof. The discontinuity presents 100% mirror at one end of the cavity. Thus, the internal pulse amplitude within the cavity is significantly larger than in a non-resonant cavity. The resonant cavity formed in this publication is an electrical analog of a Fabry-Perot.

Thus, while the art provides alternative concepts for the generation and guiding of millimeter waves, a need still exists in the art to define more efficient techniques of guiding radiation from a distributed microwave emitter, such as a transmission line, such that all of the radiation is emitted from the end of the wave guide. That is, the waveguide should act as a point source.

It is the object of this invention to have a system which provides an efficient point source of millimeter radiation.

Furthermore this invention provides a technique to guide millimeter radiation form a distributed source such that a point source of radiation is formed.

Furthermore this invention defines a transmission structure that operates on a variety of input radiation pulses such as these photoconductively or electrically generated guide such in an efficient manner.

This object is solved by a system for generating millimeter waves radiations having the features of claim 1.

A coplanar transmission line structure generates millimeter wavelength radiation into a substrate. Short pulses traveling on a transmission line with the upper half plane being air radiate into the substrate. The ratio of the velocity of the electrical pulses, with respect to the phase velocity of the radiation in the substrate, defines the angle of emission. Thus, by suitable choice of material for the substrate and its thickness, a guided wave can be produced.

By the use of a photoconductive transmission line structure electrical pulses are generated on the transmission line without loading problems, by exciting the line with a short pulse from a laser.

For a more compact millimeter waveguide source a resonant photoconductive transmission line is used, which for a given transmission line length is more efficient. This resonant cavity is excited by the high frequency sinusoidal output from a semiconductor layer.

This invention will be described in greater detail by referring to the attached drawing and a description of the preferred embodiment which follows.
- Fig. 1: is a top view of the structure used to produce picosecond electrical pulses on a transmission line;
- Fig. 2: is a side view of the system of Fig. 1 illustrating the transmission through the substrate, and direction of the output.

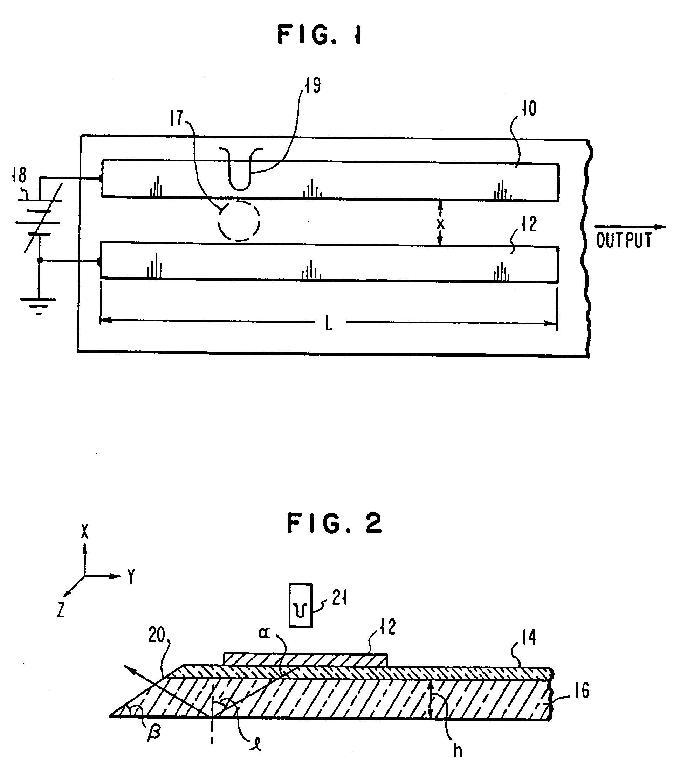

Referring now to Figs. 1-2, a preferred embodiment of this invention will be depicted. A pair of metal lines 10, 12, are formed on the surface of a damaged polycrystalline structure 14. This layer is placed on top of a suitable substrate 16 such as sapphire. The transmission lines 10 and 12 are suitable biased by means of a direct current power supply 18. Typically, they are biased in the range of 5-10 volts. The transmission lines 10 and 12 are given a critical length L and separated from each other by a distance "x". The distance x is chosen so that a diode spot 17 can be focused between the lines 10 and 12.

The diode spot 17 is produced from a laser pulse 19 that propagates from preferably a GaAs/AlGaAs semiconductor laser 21. It will be apparent to those of working skill that other lasers may be used.

By the use of a resonant transmission line structure, due to the higher intracavity fields, higher yields of millimeter radiation at a particular wave length and for a particular transmission line length can be produced. The ratio of the velocity of the electrical pulses relative to the phase velocity of the radiation in the substrate defines the angle of emission.

By suitable choice of substrate material and thickness, a guided wave can be produced. For air as the upper half plane dielectric then guiding will always occur irrespective of substrate material as long as it is transparent. In this situation, the ratio of the angle of incidence at the lower substrate/air interface (β) to the critical angle (Y) is given by (quasistatic approximation) sin/siny = (1/2(ε+1))^1/2, which always gives ℓ >Y (i.e. guiding).

For example, the substrate could be quartz where the dielectric constant ε is ∼ 4. The critical angle is about 30°. For silicon having ε ∼ 11, the critical angle would be ∼ 20°.

For instance, if the transmission lines 10 and 12 are placed on a damaged silicon on sapphire substrate (SOS) then using v=c/2.45 on the line and v=c/3.3 for high frequency radiation in the substrate, the angle of the emission is approximately 50°. This is compatible with guided radiation in the sapphire where the critical angle to air is approximately 20°.

For a cavity having an "ℓ" of 3mm, resonance would occur with an excitation of 40GHz. As determined from the equations found in Rutledge et al, "Integrated-Circuit Antennas" incorporated herein by reference, the amplitude absorption coefficient due to radiation is approximately 0.4 10-4mm-1 at 40GHz. For a bias voltage in the range of 10/V on 100/Ω lines, the radiation power at 0.75 mm wave length is in the range of 10/mw. For lines of separation of 200 »m then the radiation is in the range of 250/mw.

Referring now to Fig. 2, the structure of Fig. 2 is depicted illustrating those emission angles. An emission cone of millimeter radiation having an angle of approximately 50° is created when a diode spot is projected on the damaged poly layer 14 causing resonance. This is compatible with guided radiation in the sapphire 16 where the critical angle is approximately 20°. For angles greater then the critical angle of 20° there is total internal reflection. The output face 20 of the waveguide is angled as shown so that the millimeter radiation outputs normal to this face. The thickness, h, of the substrate should be about the wavelength of radiation (here approximately 1 mm).

A sapphire substrate of approximately 0.5 mm in thickness is suitable with the damaged poly layer of approximately 1 »m forming the SOS composite. For better confinement the wafer should be cleaved in a slab geometry having a width of a few mm (i.e. confinement in the x and z directions as defined by Fig. 2).

Higher efficiencies can also be achieved at higher frequencies (f³ dependence) in which case one would use shorter pulses with components of several hundred GHz. The bandwidth of radiation will be larger though strongly peaked toward the shorter wave lengths, with the shortest emitted wavelength at a few hundred microns.

## Claims

1. A system for generating millimeter waves radiation comprising:
a substrate (16),
a coplanar transmission line (10,12), and
means (21) to produce short pulses (19) on said transmission line which radiate into said substrate (16)
**characterized in that**
said substrate (16) has a thickness approximately equal to the millimeter wave radiation wavelength.

2. The system of claim 1,
**characterized in that**
said substrate (16) is Sapphire.

3. The system of claim 1 or 2,
**characterized in that**
said coplanar transmission line (10,12) is connected across a high frequency device.

4. The system of claim 3,
**characterized in that**
said transmission line is deposited on polycrystalline silicon with electrical pulses produced by short optical laser pulses (19) where λ is less than 1 »m.

5. The system of any one of claims 1 to 4,
**characterized in that**
said transmission line is deposited on polycrystalline silicon open at each end and whose length is such that a semiconductor laser (21) with a particular modulation frequency will produce a wave on the transmission line so that the round trip time of the electical pulse is equal to repetition rate of laser modulation.

6. The system of any one of claims 1 to 5,
**characterized by**
means (18) to bias said transmission line.

7. The system of claim 3 or 4,
**characterized in that**
said high frequency device is an IMPATT diode.

## Patentansprüche

1. System zur Erzeugung von Millimeterwellen-Strahlung, umfassend:
ein Substrat (16),
eine koplanare Übertragungsleitung (10, 12), und
Mittel (21) zur Erzeugung kurzer Impulse (19) auf der Transmissionsleitung, die in das Substrat strahlen (16),
dadurch gekennzeichnet, daß
das Substrat (16) eine Dicke ungefähr gleich der Wellenlänge der Millimeterwellen-Strahlung aufweist.

2. System nach Anspruch 1,
dadurch gekennzeichnet, daß
das Substrat (16) Saphir ist.

3. System nach Anspruch 1 oder 2,
dadurch gekennzeichnet, daß
die koplanare Übertragungsleitung (10, 12) über ein Hochfrequenzbauteil verbunden ist.

4. System nach Anspruch 3
dadurch gekennzeichnet, daß
die Übertragungsleitung auf polykristallinem Silicium mit elektrischen Impulsen, die durch kurze optische Laserimpulse (19) erzeugt werden, wobei λ weniger als 1 »m ist, abgeschieden wird.

5. System nach irgendeinem der Ansprüche 1 bis 4,
dadurch gekennzeichnet, daß
die Übertragungsleitung offen an beiden Enden auf polykristallinem Silicium abgeschieden und deren Länge derart ist, daß ein Halbleiterlaser (21) mit einer speziellen Modulationsfrequenz eine Welle auf der Übertragungsleitung erzeugt, so daß die Umlaufzeit des elektrischen Impulses gleich der Wiederholungsrate der Lasermodulation ist.

6. System nach irgendeinem der Ansprüche 1 bis 5,
gekennzeichnet durch
Mittel (18) zum Vorspannen der Übertragungsleitung.

7. System nach Anspruch 3 oder 4,
dadurch gekennzeichnet, daß
das Hochfrequenzbauteil eine IMPATT-Diode ist.

## Revendications

1. Système pour engendrer un rayonnement d'ondes millimétriques, comprenant:
un substrat (16),
une ligne de transmission coplanaire (10, 12), et
un moyen (21) pour produire sur ladite ligne de transmission de courtes impulsions (19) qui rayonnent dans ledit substrat (16),
caractérisé en ce que
ledit substrat (16) a une épaisseur qui est approximativement égale à la longueur d'onde du rayonnement d'ondes millimétriques.

2. Système selon la revendication 1, caractérisé en ce que ledit substrat (16) est du saphir.

3. Système selon les revendications 1 ou 2, caractérisé en ce que ladite ligne de transmission coplanaire (10, 12) est connectée à un dispositif haute fréquence.

4. Système selon la revendication 3, caractérisé en ce que ladite ligne de transmission est déposée sur du silicium polycristallin avec des impulsions électriques produites par de courtes impulsions laser optiques (19) où λ est inférieur à 1 »m.

5. Système selon l'une quelconque des revendications 1 à 4, caractérisé en ce que ladite ligne de transmission est déposée sur du silicium polycristallin ouvert à chaque extrémité et dont la longueur est telle qu'un laser semiconducteur (21) avec une fréquence de modulation particulière va produire sur la ligne de transmission une onde de sorte que le temps du voyage circulaire de l'impulsion électrique soit égal au taux de répétition de la modulation laser.

6. Système selon l'une quelconque des revendications 1 à 5, caractérisé par un moyen (18) pour polariser ladite ligne de transmission.

7. Système selon les revendications 3 ou 4, caractérisé en ce que le dispositif haute fréquence est une diode IMPATT.
